(19)

Europäisches Patentamt
European Patent Office
Office européen des brevets

(11) **EP 3 255 493 A1**

(12) **EUROPEAN PATENT APPLICATION**

(43) Date of publication:
**13.12.2017   Bulletin 2017/50**

(51) Int Cl.:
***G03F 1/62*** *(2012.01)*

(21) Application number: **16173580.8**

(22) Date of filing: **08.06.2016**

| | |
|---|---|
| (84) Designated Contracting States:<br>**AL AT BE BG CH CY CZ DE DK EE ES FI FR GB<br>GR HR HU IE IS IT LI LT LU LV MC MK MT NL NO<br>PL PT RO RS SE SI SK SM TR**<br>Designated Extension States:<br>**BA ME**<br>Designated Validation States:<br>**MA MD** | • **CALADO, Victor, Emanuel**<br>  **5500 AH Veldhoven (NL)**<br>• **ROELOFS, Willem, Seine, Christian**<br>  **5500 AH Veldhoven (NL)**<br>• **VAN HAREN, Richard, Johannes, Franciscus**<br>  **5500 AH Veldhoven (NL)** |
| (71) Applicant: **ASML Netherlands B.V.**<br>  **5500 AH Veldhoven (NL)** | (74) Representative: **Peters, John Antoine**<br>  **ASML Netherlands BV**<br>  **Corporate Intellectual Property**<br>  **P.O. Box 324**<br>  **5500 AH Veldhoven (NL)** |
| (72) Inventors:<br>• **VAN DIJK, Leon, Paul**<br>  **5500 AH Veldhoven (NL)** | Remarks:<br>Claims 16-17 are deemed to be abandoned due to non-payment of the claims fees (Rule 45(3) EPC). |

(54) **METHOD OF DETERMINING PELLICLE COMPENSATION CORRECTIONS FOR A LITHOGRAPHIC PROCESS, METROLOGY APPARATUS AND COMPUTER PROGRAM**

(57)     Disclosed is a method of determining a pellicle compensation correction which compensates for a distortion of a patterning device resultant from mounting of a pellicle onto the patterning device. The method comprises determining a pellicle induced distortion from a first shape associated with the patterning device without the pellicle mounted and a second shape associated with the patterning device with the pellicle mounted, the pellicle induced distortion describing the distortion of the patterning device due to the pellicle being mounted. The determined pellicle induced distortion is then used to calculate the pellicle compensation correction for a lithographic exposure step using the patterning device.

Fig. 3

## Description

FIELD

The present invention relates to methods usable, for example, in the manufacture of devices by lithographic techniques.

BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g. comprising part of, one, or several dies) on a substrate (e.g. a silicon wafer). Transfer of the pattern is typically via imaging onto a layer of radiation-sensitive material (resist) provided on the substrate. In general, a single substrate will contain a network of adjacent target portions that are successively patterned. Known lithographic apparatuses include so-called steppers, in which each target portion is irradiated by exposing an entire pattern onto the target portion at one time, and so-called scanners, in which each target portion is irradiated by scanning the pattern through a radiation beam in a given direction (the "scanning"-direction) while synchronously scanning the substrate parallel or anti parallel to this direction. It is also possible to transfer the pattern from the patterning device to the substrate by imprinting the pattern onto the substrate.

A key performance parameter of any lithographic process, particularly one used for the manufacture of semiconductor devices, is the so-called overlay. Overlay is the accuracy (or the error) to which features in an applied pattern can be positioned directly on top of cooperating features applied to the same substrate in an earlier step. Modern lithographic processes may apply many measurements, modeling and correction steps to eliminate sources of error in the positioning of features, to achieve overlay of only a few nanometers. As the performance of lithographic apparatuses improves, reticle deformations, caused by for example clamping stresses, sagging, and reticle heating during exposures, are becoming a limiting factor for overlay improvements.

An important contribution to intrafield overlay is reticle writing error (RWE). This is a measure of the error in the writing (e.g., positioning) of features on the reticle. When the reticle is imaged, such errors will cause a corresponding positional error of the exposed structure on a substrate. To mitigate this, the RWE can be measured offline and appropriate corrections calculated and fed-forward to the lithographic apparatus during substrate positioning and/or exposure.

Another issue with imaging performance of a lithographic apparatus is contamination of the reticle. Contaminants on the reticle can be imaged onto the substrate resulting in imaging errors and a consequent negative impact on yield. To prevent this, a membrane or pellicle may be used as a physical barrier across the reticle to prevent contaminants from falling on the reticle. Such a pellicle, and therefore any contaminants on the pellicle, will be located too far out of focus to be imaged on the substrate. The pellicle may comprise a thin transparent film stretched over a frame that is attached (e.g., glued) over one side of the reticle. As a consequence, the attachment of the pellicle may result in distortions of the reticle shape. These distortions could in principle be measured using aforementioned method of measuring the RWE. However the presence of a pellicle frame does not allow direct measurement of feature positions close to the pellicle frame due to shadowing effects. As such, the offline measurement will not comprise optical measurements close to the pellicle frame.

SUMMARY

It would be desirable to mitigate for the effects of reticle distortion caused by the pellicle.

The invention in a first aspect describes a method of determining a pellicle compensation correction which compensates for a distortion of a patterning device resultant from mounting of a pellicle onto the patterning device, said method comprising:

determining a pellicle induced distortion from a first shape associated with the patterning device without the pellicle mounted and a second shape associated with the patterning device with the pellicle mounted, said pellicle induced distortion describing the distortion of the patterning device due to the pellicle being mounted; and
using the determined pellicle induced distortion to calculate the pellicle compensation correction for a lithographic exposure step using said patterning device.

The invention further provides a metrology apparatus operable to perform the method of the first aspect.

The invention further provides a method of manufacturing devices wherein a device pattern is applied to a series of substrates using a lithographic exposure process, the method including: using the method of the first aspect to determine pellicle compensation corrections, and controlling the lithographic exposure process using the pellicle compensation corrections.

The invention yet further provides a computer program product comprising machine-readable instructions for causing a processor to perform the method of the first aspect.

Further aspects, features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

Embodiments of the invention will now be described, by way of example only, with reference to the accompanying schematic drawings in which corresponding reference symbols indicate corresponding parts, and in which:

Figure 1 depicts a lithographic apparatus;
Figure 2 schematically shows (a) a reticle without pellicle attached being measured by a reticle metrology tool, (b) a reticle with pellicle attached being measured by a reticle metrology tool and (c) the effect of the shadow cast by the reticle frame on measurement of a reticle;
Figure 3 is a flow diagram schematically describing a method according to an embodiment of the invention; and
Figure 4 is a schematic detail of reticle cross-section in the region of a pellicle induced distortion.

DETAILED DESCRIPTION OF EXEMPLARY EMBODIMENTS

Before describing embodiments of the invention in detail, it is instructive to present an example environment in which embodiments of the present invention may be implemented.

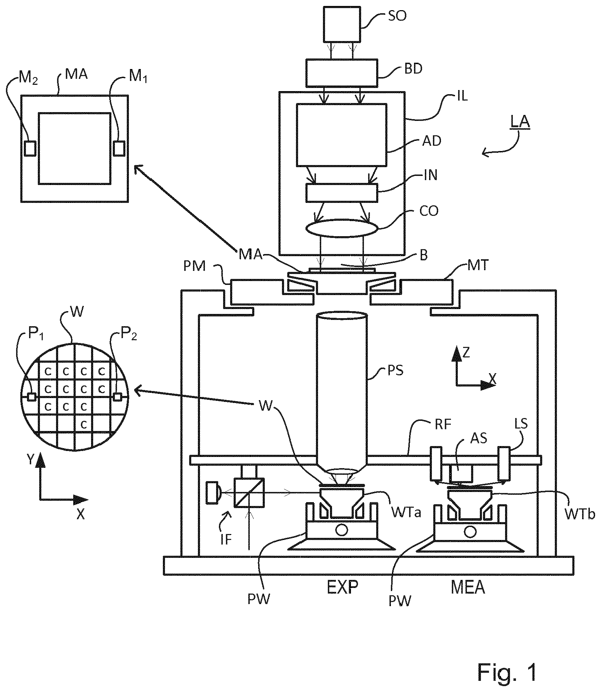

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a reticle or mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.
The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support MT may be a frame or a table, for example, which may be fixed or movable as required. The patterning device support may ensure that the patterning device is at a desired position, for example with respect to the projection system.
The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.
As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.
The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".
The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment mark may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment marks on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

A patterning device (hereafter referred to as a reticle) typically comprises a pattern consisting of patterning structures formed of an opaque material (e.g., chrome) which are written onto a transparent substrate. It is important that the patterning structures are positioned accurately onto the reticle substrate during the reticle writing process, as positional errors contribute to overlay errors on the substrate during exposure. An off-line reticle metrology device or position metrology tool, such as an off-line mask registration measurement tool, may be used to perform registration measurements on a reticle. Reticle registration comprises determining the relative positions of patterning structures on the reticle, thereby verifying structure placement performance on the reticles. The results of such reticle registration can be used to monitor the reticle writing process and to qualify a reticle.

It is also possible to characterize a reticle writing error (RWE) fingerprint using such an off-line registration measurement tool or other position metrology tool and to use this information to determine and feed-forward corrections to the lithographic apparatus during exposure of a substrate using the reticle. The RWE fingerprint may describe distortions (linear and (possibly) higher order) in the image field on the reticle (e.g., structure position errors). In this way, both linear and higher order structure position error (e.g., RWE) corrections may be determined which correct for these distortions. Being an off-line measurement, a dense measurement of a reticle may be performed. This can be done for every reticle. Such a concept is described, for example, in "Higher order feed-forward control of reticle writing error fingerprints"; van Haren et al; Proc. of SPIE Vol. 9635 963507-1.

In order to measure all reticle features accurately, the reticle registration measurements should be performed without a pellicle whereas actual exposures are performed with a pellicle to prevent contaminants on the reticle affecting the exposure. Ideally, the reticle registration measurements would also be measured with pellicle in place. This is not possible (at least for a desirably dense measurement) as the pellicle frame casts a shadow which prevents measurement of data points in the vicinity of the frame, measurements consequently being limited to data points that are not too close to reticle edge. However, the reticle edge is where alignment marks and Reticle Shape Correction (RSC) marks are typically located. Alignment marks are used for aligning the reticle stage to the substrate stage and RSC marks are used for measuring reticle unflatness for the determination of focus corrections during exposure. Additionally, the reticle edge is where pellicle induced distortion is expected to be highest. Consequently, RWE corrections based on measurements of only data points away from the reticle edge will be highly compromised.

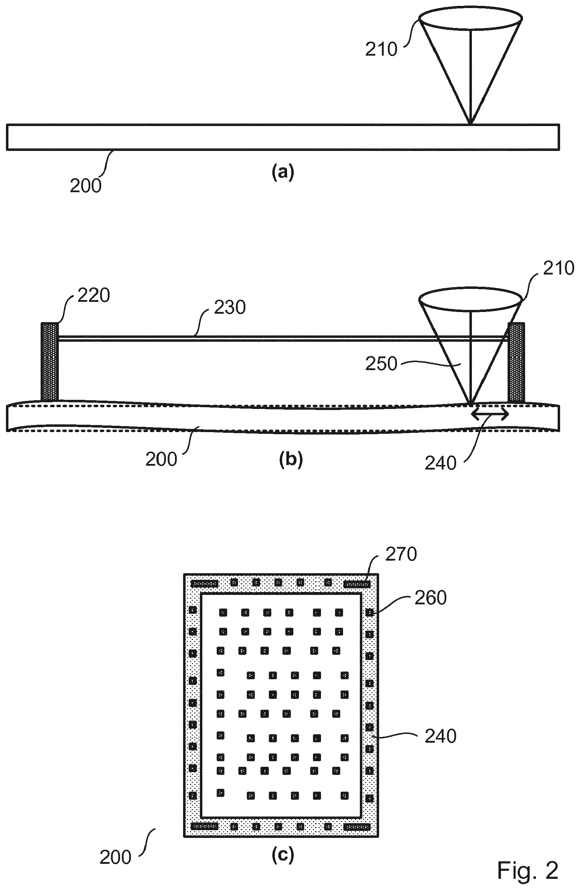

Figure 2 schematically illustrates the problem described above. Figure 2(a) shows a reticle 200 being measured by a reticle metrology device, represented by the final lens 210 of the projection optics of the reticle metrology device. Note that the reticle is shown perfectly flat in this diagram to help illustrate the effects of pellicle induced distortion. Of course, this will not be the situation in reality.

Figure 2(b) schematically illustrates the reticle 200 being measured with pellicle frame 220, holding pellicle 230, mounted. The mounting of pellicle frame 220 to reticle 200 results in a (further) distortion of the reticle 200 with respect to the reticle 200 shape without the pellicle frame 220 mounted. This effect is exaggerated in the diagram, the dotted line showing the reticle shape before pellicle frame 220 mounting (i.e., the shape of the reticle in Figure 2(a)) for reference. Also notable is the "shadow" 240 (area of reticle which cannot be measured by the reticle metrology device) cast by the pellicle frame 220. The pellicle frame 220 is required to be sufficiently tall to hold the pellicle 230 (and therefore any contaminants thereon) outside of the focal range of the exposure projection system during exposure using the reticle. As a result of this, the pellicle frame 220 will block a part of the illumination cone 250 when the final lens 210 of the projection optics is in the vicinity of the pellicle frame 220. The area of the reticle for which some of the illumination cone 250 is blocked by the pellicle frame 220 defines the shadow 240 in which the reticle 200 cannot be measured.

Figure 2(c) schematically illustrates the result of the effect of the shadow 240. It shows a plan view of the reticle 200 (pellicle 230 and pellicle frame 220 are not shown for clarity). The reticle 200 comprise a plurality of metrology marks 260, for measurement by the reticle metrology apparatus. Also shown are alignment marks 270 in each corner which are provided for measurement by an alignment sensor on an exposure apparatus as part of an alignment process. Some of the metrology marks 260 (particularly those at the periphery of the reticle) may be RSC marks provided for measurement by an alignment sensor (instead of or in addition to measurement by the reticle metrology device) as part of a reticle shape correction process. A shaded area 240 is shown, this representing the shadow cast by the pellicle frame 220. As can be seen, a number of metrology marks 260 (which would include any RSC marks if present), and the alignment marks 270, are within the shadow 240 and therefore cannot be measured by a reticle metrology tool (such as a mask registration measurement tool) when the pellicle frame 220 is attached.

It is therefore envisaged to use offline reticle shape (e.g., topography) measurements to correct for pellicle induced overlay errors. Such a concept is analogous to feed-forward lithography corrections based on measurements of substrate shape (substrate height map). The method comprises measuring the reticle shape (e.g., performing a height map measurement of the reticle) before mounting of the pellicle and again after mounting of the pellicle. From these measurements, the distortion (change in reticle shape) resultant from mounting of the pellicle can be determined, e.g., from a difference of the measurements with and without the pellicle mounted. The effect of pellicle induced distortion can be modelled and then fed forward to improve the structure position error (reticle writing error) corrections. As such, the effect on the position of patterning structures written on the reticle and/or the effect on the position of exposed structures on the substrate (and therefore the effect on overlay) resultant from the pellicle induced distortion can be modelled.

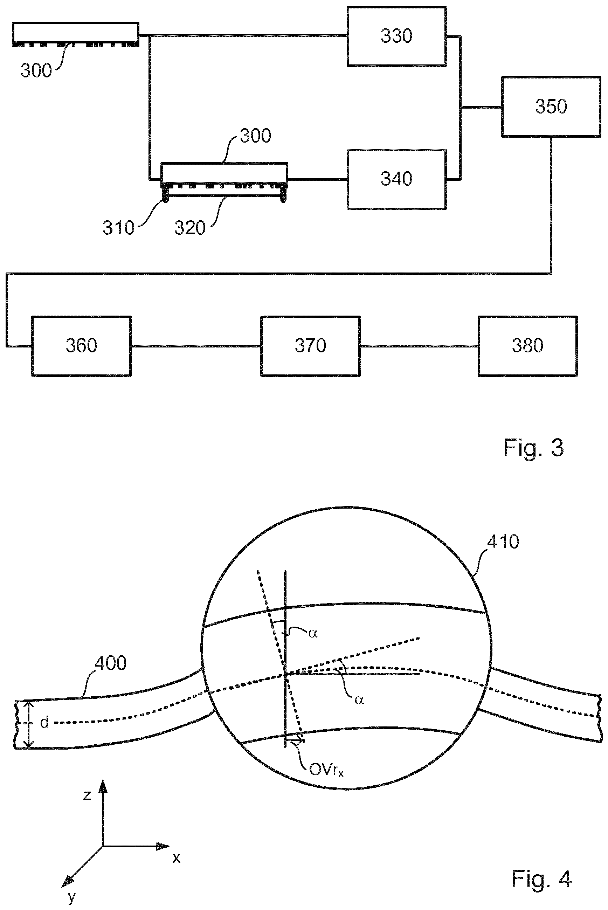

Figure 3 is a flowchart of the steps of such a method according to an exemplary embodiment. The steps are as follows, and are then described in greater detail thereafter:

> 300- Reticle.
> 310- Pellicle frame.
> 320- Pellicle.
> 330- Measure reticle shape without pellicle (first measurement).
> 340- Measure reticle shape with pellicle (second measurement).
> 350- Determine pellicle induced distortion.
> 360- Model effect of pellicle induced distortion.
> 370- Determine pellicle induced overlay errors.
> 380- Feed forward errors to lithographic apparatus (exposure tool).

At step 330, the shape of a reticle 300 (without pellicle mounted) is measured using a metrology tool. At step 340, the shape of reticle 300, with pellicle 320 mounted via pellicle frame 310, is measured using the metrology tool. The metrology tool may comprise a tool for measuring the reticle shape (e.g., reticle height or unflatness) over the reticle area. Such a tool may measure the position of alignment and/or RSC marks or similar marks on the reticle. In an embodiment, such a tool may comprise a reticle metrology tool able to measure the shape (unflatness) of a reticle; for example, a reticle level sensor. The reticle level sensor may be used to scan the surface of the reticle at a plurality of points so as to construct a three-dimensional map of the reticle. Such a reticle level sensor may be known as part of a focus error detection/correction system.

The reticle metrology tool used in steps 330 and 340 may be of a type able to measure the reticle shape over the whole reticle including in the vicinity of the pellicle frame. In an embodiment, this may comprise a reticle metrology tool operable to perform a shape measurement of the opposite side of the reticle to that attached to the pellicle. For example, where the pellicle is mounted to the front side of the reticle, the shape measurement may be of the back side of the reticle (such a reticle metrology tool may operate in reflection, where a metrology registration tool may operate in transmission). Any additional contribution to a measurement of the back side of the reticle with respect to a measurement of the front side would be expected to be the same for both measurement steps 330, 340 (e.g., before and after pellicle mounting) and therefore would be cancelled at step 350 (e.g., by taking the difference of the first and second measurements), leaving only the pellicle induced distortion.

At step 350 the pellicle induced distortion is determined from the reticle shape measurements of steps 330 and 340 (e.g., by a difference of the measurements). At step 360, a model is used to model the effect of the pellicle induced distortion. Such a model may comprise an empirical model or a more advanced computational model (e.g. based on finite elements methods). The latter, in principle, is capable of taking into account the complex interaction between the reticle and the reticle stage. At step 370, the expected pellicle induced overlay errors are determined and at step 380 these expected pellicle induced overlay errors are fed forward to the lithographic apparatus as exposure corrections.

The modelling and determination of overlay errors described in steps 360 and 370 may be analogous to the modelling and determination of overlay errors resultant from changes in substrate distortion between different exposure steps (e.g., exposure of different layers). As such, the modelling step may use a model similar to that used when modelling substrate distortion changes. However, the model is adapted for modeling reticle distortion. In contrast to a reticle, a distorted substrate is pulled flat on the chuck. Due to the top film stress, the neutral surface of the substrate (where there is no stress and strain) does not coincide with the mid-surface. Therefore, some distortion remains after the substrate is pulled flat on the chuck. A result of this is that the model factor for the model described below is d/2, where a substrate model may use a factor of d/6.

Figure 4 shows a detail of a pellicle induced distortion of a reticle. Shown in cross section is part of a reticle 400, of thickness d, at a location where there is a distortion resulting in a variation in height (z-direction). Within circle 410, the substrate is shown magnified. The reticle deformation results in a local rotation of the reticle plane (x/y) plane, which can be derived from the gradient $\nabla z$ of the reticle surface. In an embodiment, a linear model can be used to model the effect of the pellicle induced distortion on position of reticle patterning structures or the position of exposed structures (and therefore overlay). The product features (patterning structures) are formed on the bottom surface of the reticle (e.g., in chrome). The displacement of this bottom surface by rotation is proportional to the reticle thickness d. The impact on overlay on the substrate will be dependent on (multiplied by) the magnification of the projection optics of the lithographic apparatus. In a specific embodiment, this magnification is 0.25 (i.e., the projection optics impose a 4 times reduction or de-magnification) and therefore the overlay impact is 4 times smaller at substrate level than at reticle level.

Referring to Figure 4, the positional error (RWE) in the x-direction on the reticle $OVr_x$, due to the pellicle mounting, can be determined by:

$$ OVr_x = \alpha \times \frac{d}{2} = \frac{dz}{dx} \times \frac{d}{2} $$

where $\alpha$ is the angle of the (distorted) reticle plane at location x.

Consequently the positional error on the substrate $OVs_x$, and therefore the overlay contribution, due to the pellicle mounting will be:

$$OVs_x = \mathrm{m}\frac{dz}{dx} \times \frac{d}{2}$$

where m is the magnification of the projection optics.

More generally, the positional error on the substrate over the substrate plane due to the pellicle mounting $OVs_{x,y}$ will be:

$$OVs_{x,y} = \mathrm{m}\nabla z \times \frac{d}{2}$$

In this manner, the shift in position of a product feature written on a reticle (RWE) and/or exposed on a substrate (overlay error) resultant from mounting of a pellicle to the reticle can be calculated and fed forward as exposure corrections which compensate for this pellicle induced position shift. In a specific example, the shift in position of a product structure written on a reticle resultant from mounting of a pellicle can be calculated and used to correct positional measurements of the structure on the reticle performed without the pellicle in place. Such a method may optionally comprise performing the initial positional measurements of patterning structures on a reticle, e.g., using a reticle registration tool.

The concepts disclosed herein enable simplification of the control strategies in a fabrication plant. An understood overlay contribution could be taken out of the feedback control loops and sent as feed-forward corrections to the exposure tool. The disclosed concepts improve in principle the accuracy of the feed-forward corrections based on offline reticle registration measurements.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat-panel displays, liquid-crystal displays (LCDs), thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist), a metrology tool and/or an inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of or about 365, 355, 248, 193, 157 or 126 nm) and extreme ultra-violet (EUV) radiation (e.g. having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

While specific embodiments of the invention have been described above, it will be appreciated that the invention may be practiced otherwise than as described. For example, the invention may take the form of a computer program containing one or more sequences of machine-readable instructions describing a method as disclosed above, or a data storage medium (e.g. semiconductor memory, magnetic or optical disk) having such a computer program stored therein.

The descriptions above are intended to be illustrative, not limiting. Thus, it will be apparent to one skilled in the art that modifications may be made to the invention as described without departing from the scope of the claims set out below.

## Claims

1. A method of determining a pellicle compensation correction which compensates for a distortion of a patterning device resultant from mounting of a pellicle onto the patterning device, said method comprising:

   determining a pellicle induced distortion from a first shape associated with the patterning device without the pellicle mounted and a second shape associated with the patterning device with the pellicle mounted, said pellicle induced distortion describing the distortion of the patterning device due to the pellicle being mounted; and
   using the determined pellicle induced distortion to calculate the pellicle compensation correction for a lithographic exposure step using said patterning device.

2. A method as claimed in claim 1 wherein said step of calculating pellicle compensation corrections comprises predicting the positional shift of patterning structures on the patterning device and/or corresponding positional shifts of exposed structures on the substrate following said exposure step, which result from said pellicle induced distortion.

3. A method as claimed in claim 1 or 2 comprising said lithographic exposure step, wherein said lithographic exposure step is performed by a lithographic apparatus and said pellicle compensation corrections are fed forward to said lithographic apparatus to correct said lithographic exposure step.

4. A method as claimed in claim 3 comprising:

performing a measurement of the position of patterning structures on said patterning device; calculating structure position error corrections based on said measurement of the position of patterning structures on said patterning device; and combining the structure position corrections and the pellicle compensation corrections to obtain combined corrections and feeding the combined corrections forward to said lithographic apparatus to correct said lithographic exposure step.

5. A method as claimed in any preceding claim wherein said pellicle compensation corrections comprise corrections in the position of exposed structures during said exposure step which compensate for said pellicle induced distortion.

6. A method according to any preceding claim, further comprising:

performing a first measurement of the patterning device, said first measurement of the patterning device comprising measuring said first shape, said first shape comprising the shape of the patterning device with no pellicle mounted to the patterning device; and performing a second measurement of the patterning device, said second measurement of the patterning device comprising measuring said second shape, said second shape comprising the shape of the patterning device with a pellicle mounted to the patterning device.

7. A method as claimed in claim 6 wherein said first measurement and said second measurement are offline measurements, performed prior to said lithographic exposure step.

8. A method as claimed in claim 6 or 7 wherein said first measurement and said second measurement each comprise a height profile of the patterning device.

9. A method as claimed in claim 6, 7 or 8 wherein said first measurement and said second measurement are each performed using a patterning device level sensor.

10. A method as claimed in any of claims 6 to 9 wherein said first measurement and said second measurement each comprise a measurement of the opposite side of the patterning device than that to which said pellicle is mounted.

11. A method as claimed in any preceding claim comprising performing said lithographic exposure step using said pellicle compensation corrections.

12. A metrology apparatus operable to perform the method of any of claims 6 to 10.

13. A metrology apparatus as claimed in claim 12 comprising:

a support for said patterning device; a patterning device level sensor operable to perform said first measurement and said second measurement; and a processor.

14. A lithographic apparatus comprising the metrology apparatus as claimed in claim 12 or 13; and further operable to apply a device pattern comprised on said patterning device to a series of substrates using a lithographic exposure process.

15. A computer program comprising processor readable instructions which, when run on suitable processor controlled apparatus, cause the processor controlled apparatus to perform the method of any one of claims 1 to 11.

16. A computer program carrier comprising the computer program of claim 15.

17. A method of manufacturing devices wherein a device pattern is applied to a series of substrates using a lithographic exposure process, the method including:

- using the method of any of claims 1 to 10 to determine pellicle compensation corrections, and controlling the lithographic exposure process using the pellicle compensation corrections.

Fig. 1

Fig. 2

Fig. 3

Fig. 4

Europäisches
Patentamt

European
Patent Office

Office européen
des brevets

# EUROPEAN SEARCH REPORT

Application Number

EP 16 17 3580

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE KRUIF R ET AL: "Reduced pellicle impact on overlay using high order intrafield grid corrections", PROCEEDINGS OF THE SPIE - THE INTERNATIONAL SOCIETY FOR OPTICAL ENGINEERING SPIE - THE INTERNATIONAL SOCIETY FOR OPTICAL ENGINEERING USA, vol. 7470, 2009, XP002769539, ISSN: 0277-786X * paragraphs [0003], [0004], [0005], [0007]; figures 4,5,6 * ----- | 1-5,11, 15 | INV. G03F1/62 |
| A | SERVIN I ET AL: "Mask contribution on CD and OVL errors budgets for double patterning lithography", PROCEEDINGS OF THE SPIE - THE INTERNATIONAL SOCIETY FOR OPTICAL ENGINEERING SPIE - THE INTERNATIONAL SOCIETY FOR OPTICAL ENGINEERING USA, vol. 7470, 2009, XP002769540, ISSN: 0277-786X * paragraph [0005] * ----- | 1-15 | |

TECHNICAL FIELDS
SEARCHED (IPC)

G03F

The present search report has been drawn up for all claims

| Place of search | Date of completion of the search | Examiner |
|---|---|---|
| The Hague | 26 April 2017 | Pérennès, Frédéric |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.................................................................................

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **VAN HAREN et al.** Higher order feed-forward control of reticle writing error fingerprints. *Proc. of SPIE,* vol. 9635